# EUROPEAN PATENT APPLICATION

(11) **EP 1 575 172 A2**
(43) Date of publication of application: **14.09.2005**
(21) Application number: 05101641.8
(22) Date of filing: 03.03.2005
(51) Int. Cl.: H03M 7/30, G06F 17/30

(54) **Compression of logs of language data**

(30) Priority: 09.03.2004 US 796644
(71) Applicant: MICROSOFT CORPORATION, Redmond, WA 98052 (US)
(72) Inventor: Hon, Hsiao-Wuen, Redmond, WA 98052 (US); Leonard, Peter F., Redmond, WA 98052 (US); Meredith, Scott E., Redmond, WA 98052 (US)
(74) Representative: Grünecker, Kinkeldey, Stockmair & Schwanhäusser Anwaltssozietät

(57) **Abstract**

A method and apparatus for compressing query logs is provided. Multiple levels of user-specifiable compression include character-based compression, token-based compression, and subsumption. An efficient method for performing subsumption is also provided. The compressed query logs are then used to train a statistical process such as a help function for a computer operating system.

## Description

### BACKGROUND OF THE INVENTION

The present invention is related to computerized logs of natural language data. More particularly, the present invention is related to a method and system for condensing computerized logs of natural language data.

Logs of language data, as used herein, include two or more linguistic strings that are generated by people. These logs can be generated in a variety of contexts. For example, such logs are generated in environments where one or more users are attempting to interact with a large-scale data collection. One particular example of this environment is where users generate help queries in order to find help topics with respect to a computer system. For example, one such query might include, "How do I install a printer." Another example might be, "How do I configure a firewall on my computer."

Logs of millions of actual user queries exist and can be used by system manufacturers as valuable sources of information about the relation between user help needs/goals and their expressive or linguistic tendencies. When queries are associated to user interest in the form of defined system task designators, these logs can be used to train statistical query classifiers for next-generation help services. In addition, such logs can be mined for ideas with respect to help tasks that should be added. Finally, the "real" or usable actual size, or principle measure of the real semantic content/size or value-added of a given log is better determined by counting normalized forms rather than a count of raw query strings.

As computer systems have become larger and more feature-rich, providing an efficient and intuitive help system has become even more important. However, the significant complexity of the number of different ways a given query can be stated, compounded by the vast number of additional features and functions provided in today's computer systems, can mean that natural language query logs can include millions of such queries. Certainly, manually reading through and training a query search engine based upon these vast logs would be extremely time consuming. However, each and every query in the log potentially represents important data that would be useful to enhance the accuracy of the search. Simply discarding individual queries in the log to generate a more manageable size is undesirable.

Providing a system and methods that could facilitate the manipulation of large-scale natural language data logs, such as query logs, would be useful to the art. Moreover, it would be very beneficial if such manipulation could be done in a manner that maintains the linguistic meaning of such queries while still reducing the vast size of these natural language data logs.

### SUMMARY OF THE INVENTION

A method and apparatus for compressing query logs is provided. Multiple levels of user-specifiable compression include character-based compression, token-based compression, and subsumption. An efficient method for performing subsumption is also provided. The compressed query logs are then used to train a statistical process such as a help function for a computer operating system.

### BRIEF DESCRIPTION OF THE DRAWINGS

FIG. 1 is a diagrammatic view of a suitable computing environment for practicing embodiments of the present invention.
FIG. 2 is a diagrammatic view of a system for compressing query logs in accordance with an embodiment of the present invention.
FIG. 3 is a flow diagram of a method of automatically training a statistical process in accordance with an embodiment of the present invention.
FIG. 4 is a flow diagram of a method of performing subsumption in accordance with an embodiment of the present invention.

### DETAILED DESCRIPTION OF ILLUSTRATIVE EMBODIMENTS

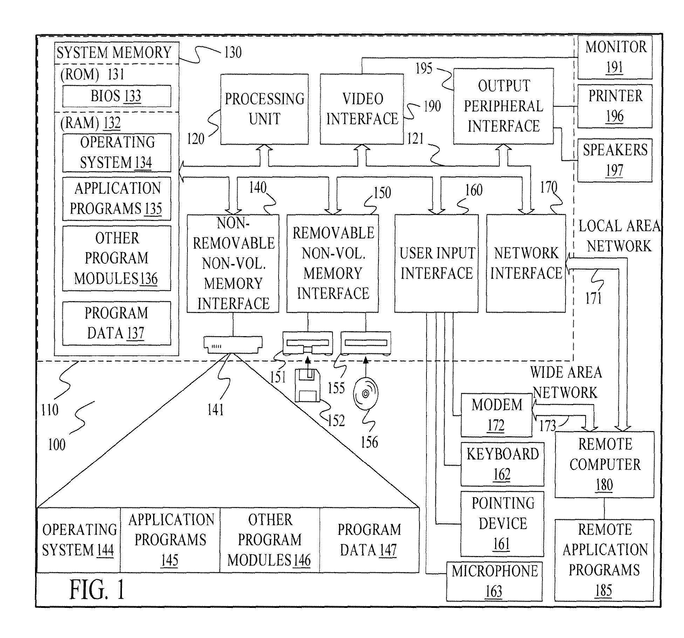

FIG. 1 illustrates an example of a suitable computing system environment 100 on which the invention may be implemented. The computing system environment 100 is only one example of a suitable computing environment and is not intended to suggest any limitation as to the scope of use or functionality of the invention. Neither should the computing environment 100 be interpreted as having any dependency or requirement relating to any one or combination of components illustrated in the exemplary operating environment 100.

The invention is operational with numerous other general purpose or special purpose computing system environments or configurations. Examples of well-known computing systems, environments, and/or configurations that may be suitable for use with the invention include, but are not limited to, personal computers, server computers, hand-held or laptop devices, multiprocessor systems, microprocessor-based systems, set top boxes, programmable consumer electronics, network PCs, minicomputers, mainframe computers, telephony systems, distributed computing environments that include any of the above systems or devices, and the like.

The invention may be described in the general context of computer-executable instructions, such as program modules, being executed by a computer. Generally, program modules include routines, programs, objects, components, data structures, etc. that perform particular tasks or implement particular abstract data types. The invention may also be practiced in distributed computing environments where tasks are performed by remote processing devices that are linked through a communications network. In a distributed computing environment, program modules may be located in both local and remote computer storage media including memory storage devices.

With reference to FIG. 1, an exemplary system for implementing the invention includes a general-purpose computing device in the form of a computer 110. Components of computer 110 may include, but are not limited to, a central processing unit 120, a system memory 130, and a system bus 121 that couples various system components including the system memory to the processing unit 120.

The system bus 121 may be any of several types of bus structures including a memory bus or memory controller, a peripheral bus, and a local bus using any of a variety of bus architectures. By way of example, and not limitation, such architectures include Industry Standard Architecture (ISA) bus, Micro Channel Architecture (MCA) bus, Enhanced ISA (EISA) bus, Video Electronics Standards Association (VESA) local bus, and Peripheral Component Interconnect (PCI) bus also known as Mezzanine bus.

Computer 110 typically includes a variety of computer readable media. Computer readable media can be any available media that can be accessed by computer 110 and includes both volatile and nonvolatile media, removable and non-removable media. By way of example, and not limitation, computer readable media may comprise computer storage media and communication media. Computer storage media includes both volatile and nonvolatile, removable and non-removable media implemented in any method or technology for storage of information such as computer readable instructions, data structures, program modules or other data. Computer storage media includes, but is not limited to, RAM, ROM, EEPROM, flash memory or other memory technology, CD-ROM, digital versatile disks (DVD) or other optical disk storage, magnetic cassettes, magnetic tape, magnetic disk storage or other magnetic storage devices, or any other medium which can be used to store the desired information and which can be accessed by computer 110. Communication media typically embodies computer readable instructions, data structures, program modules or other data in a modulated data signal such as a carrier wave or other transport mechanism and includes any information delivery media. The term "modulated data signal" means a signal that has one or more of its characteristics set or changed in such a manner as to encode information in the signal. By way of example, and not limitation, communication media includes wired media such as a wired network or direct-wired connection, and wireless media such as acoustic, RF, infrared and other wireless media. Combinations of any of the above should also be included within the scope of computer readable media.

The system memory 130 includes computer storage media in the form of volatile and/or nonvolatile memory such as read only memory (ROM) 131 and random access memory (RAM) 132. A basic input/output system 133 (BIOS), containing the basic routines that help to transfer information between elements within computer 110, such as during start-up, is typically stored in ROM 131. RAM 132 typically contains data and/or program modules that are immediately accessible to and/or presently being operated on by processing unit 120. By way of example, and not limitation, FIG. 1 illustrates operating system 134, application programs 135, other program modules 136, and program data 137.

The computer 110 may also include other removable/non-removable volatile/nonvolatile computer storage media. By way of example only, FIG. 1 illustrates a hard disk drive 141 that reads from or writes to non-removable, nonvolatile magnetic media, a magnetic disk drive 151 that reads from or writes to a removable, nonvolatile magnetic disk 152, and an optical disk drive 155 that reads from or writes to a removable, nonvolatile optical disk 156 such as a CD ROM or other optical media. Other removable/non-removable, volatile/nonvolatile computer storage media that can be used in the exemplary operating environment include, but are not limited to, magnetic tape cassettes, flash memory cards, digital versatile disks, digital video tape, solid state RAM, solid state ROM, and the like. The hard disk drive 141 is typically connected to the system bus 121 through a non-removable memory interface such as interface 140, and magnetic disk drive 151 and optical disk drive 155 are typically connected to the system bus 121 by a removable memory interface, such as interface 150.

The drives and their associated computer storage media discussed above and illustrated in FIG. 1, provide storage of computer readable instructions, data structures, program modules and other data for the computer 110. In FIG. 1, for example, hard disk drive 141 is illustrated as storing operating system 144, application programs 145, other program modules 146, and program data 147. Note that these components can either be the same as or different from operating system 134, application programs 135, other program modules 136, and program data 137. Operating system 144, application programs 145, other program modules 146, and program data 147 are given different numbers here to illustrate that, at a minimum, they are different copies.

A user may enter commands and information into the computer 110 through input devices such as a keyboard 162, a microphone 163, and a pointing device 161, such as a mouse, trackball or touch pad. Other input devices (not shown) may include a joystick, game pad, satellite dish, scanner, or the like. These and other input devices are often connected to the processing unit 120 through a user input interface 160 that is coupled to the system bus, but may be connected by other interface and bus structures, such as a parallel port, game port or a universal serial bus (USB). A monitor 191 or other type of display device is also connected to the system bus 121 via an interface, such as a video interface 190. In addition to the monitor, computers may also include other peripheral output devices such as speakers 197 and printer 196, which may be connected through an output peripheral interface 190.

The computer 110 may operate in a networked environment using logical connections to one or more remote computers, such as a remote computer 180. The remote computer 180 may be a personal computer, a hand-held device, a server, a router, a network PC, a peer device or other common network node, and typically includes many or all of the elements described above relative to the computer 110. The logical connections depicted in FIG. 1 include a local area network (LAN) 171 and a wide area network (WAN) 173, but may also include other networks. Such networking environments are commonplace in offices, enterprise-wide computer networks, intranets and the Internet.

When used in a LAN networking environment, the computer 110 is connected to the LAN 171 through a network interface or adapter 170. When used in a WAN networking environment, the computer 110 typically includes a modem 172 or other means for establishing communications over the WAN 173, such as the Internet. The modem 172, which may be internal or external, may be connected to the system bus 121 via the user input interface 160, or other appropriate mechanism. In a networked environment, program modules depicted relative to the computer 110, or portions thereof, may be stored in the remote memory storage device. By way of example, and not limitation, FIG. 1 illustrates remote application programs 185 as residing on remote computer 180. It will be appreciated that the network connections shown are exemplary and other means of establishing a communications link between the computers may be used.

In accordance with one broad aspect of embodiments of the present invention, a raw query log 300 is provided as an input to compression module 302. Compression module is preferably embodied upon a computing system as set forth above, but may be embodied in any suitable manner including hardware, software, or a combination of the two. Compression module 302 is adapted to perform one or more query log compression operations upon raw query log 300 to generate compressed query log 304. The query log compression operations are set forth below in greater detail. For ease of illustration, the query log compression operations are classified according to the level of compression that they provide. Preferably, there are three operator-specifiable levels of compression: low, medium and high.

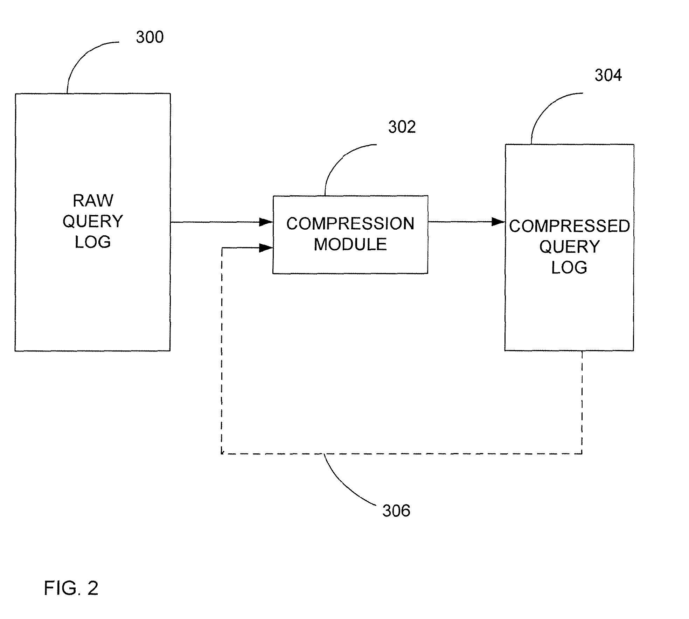

Compression module 302 can be embodied in any system capable of executing one ore more of the query log compression operations set forth below. Accordingly, compression module 302 can be computer hardware, such as that set forth above, computer software embodied in any suitable programming language, or any combination of the two. FIG. 2 also illustrates dashed line 306 in order to illustrate that the compressed query log 304 can be fed back to compression module 302 in order to take multiple compression passes on the log.

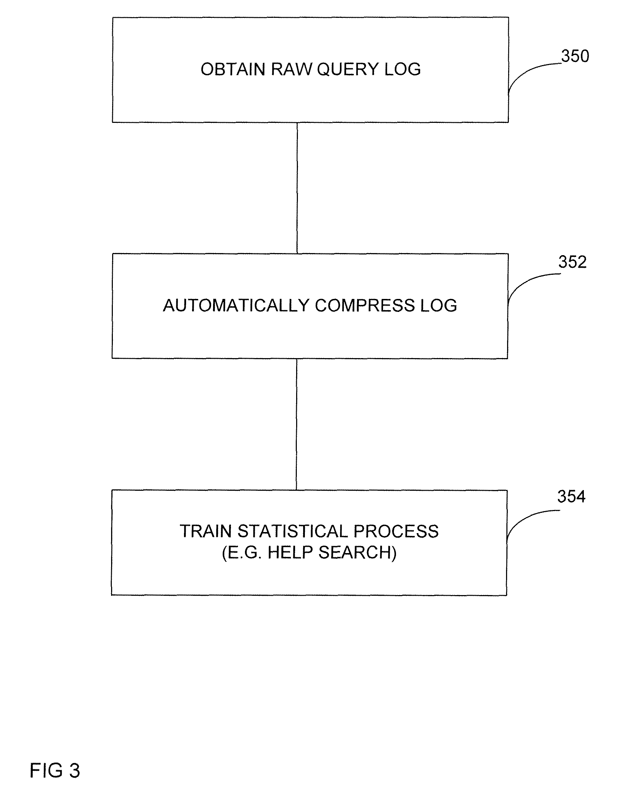

FIG. 3 is a flow diagram of a method of training a statistical process in accordance with an embodiment of the present invention. The method begins at block 350 where a raw query log, such as query log 300 is obtained. At block 352, the raw query log is compressed one or more times to generate a compressed query log, such as compressed query log 304. The compressed query log is then used in block 354 to train the statistical process. The actual methods and techniques used to train the statistical process can be any suitable methods and techniques known in the art.

As set forth above, the individual query log operations are preferably classified in three levels according to the degree of compression. The following listing is exemplary and is not meant to limit embodiments of the present invention.

Low-compression operations are typically character-based. Such operations include case normalization, removing rare symbols, normalizing varying white space to blank, checking for completely unusable input, etc. Preferably, an operation is performed upon each query in the log. Once the operations are performed upon at least a significant number, and preferably all, queries, a matching operation is executed to determine if any of the normalized queries match each other, thereby allowing one of the matching queries to be removed from the log.

Normalizing case is an operation wherein all characters of a given query are changed to a specific case, such as "Install Printer" being transformed to "install printer". An example of removing rare symbols is where input text, such as "§ 204" is transformed to "section 204". Normalizing varying white space to blank is an operation wherein a query such as "Windows 98" is transformed to "Windows 98". Finally, checking for unusable input is simply that, wherein gibberish such as "acxpt; 24" is simply discarded.

Medium compression operations are used to remove very frequent grammatical function words, detect and normalize variant spellings or phrasings of frequent concepts, fold synonyms into a single canonical semantic term, attempt spelling correction, reduce inflected words to their linguistic base form, and sort the word tokens in each query. These operations are typically not character-based, but instead are based on words. These operations preferably use known spelling, thesaurus, and natural language processing technologies to identify and standardize words in individual queries. For example, an input query of: "How do I get rid of firewalls in Win 98?" will be normalized to, "<firewall> <REMOVE><WIN_98>". As can be seen, the words "How do I get", "of", and "in" are discarded as grammatical function words. The word "rid" is folded into a single canonical semantic term <REMOVE>, and Win 98 is standardized to <WIN_98>. Again, once the medium compression operations are applied to at least some, and preferably all, queries, a matching operation is executed to determine if any of the medium-compressed queries match each other, thereby allowing removal of one the matching queries from the log.

The highest degree of query log compression is referred to herein as subsumption. This is a process wherein individual queries are scanned or otherwise processed to identify similarities to such an extent that a single word difference between a pair of queries can be evaluated to determine the degree to which the single word changes the meaning of the query. In situations where the meaning of the additional word is adds relatively little to the query, the additional word can be discarded and the pair of queries can be collapsed into a single query by omitting the additional word. This is not a trivial process. Essentially, the subsumption process examines the entire log for queries that are super strings of some other query. If the extra material is deemed statistically irrelevant, the normalized form of the given substring will be taken as the normalized form of the super string. For example, the following two queries will be subsumed in the following manner.
"Change mouse speed"
"Change mouse click speed"

As can be seen the latter is a superstring of the former and could be folded into a single query bundle if the word "click" could be determined statistically to be unlikely to distinguish two separate intents, via global examination of the entire log vocabulary. In other words, subsumption works by first finding two queries that differ minimally (perhaps just by a single word) and then deciding how "important" that one word difference is likely to be based upon such things as natural language processing and the like.

While the first two levels of query log compression generally operate on individual, isolated queries, subsumption may include two or more passes over the entire query log (potentially millions of queries). After the per-query isolated normalizing operations have been applied, it is sometimes possible use subsumption to merge longer, more elaborately worded queries with simpler, but functionally equivalent counter parts. For example, the four-word query "change mouse pointer icon" and the three-word query "change mouse pointer" are effectively equivalent and the longer one can be normalized to (and subsequently "bundled" together with) the shorter one without operational loss or a significant change in meaning. This subsumption process is not the same as simply keeping a list of words such as "icon" that can always be deleted without apparent loss, because it is not generally true that "icon" is redundant. The comparative nature of subsumption means that there is a justification, usually based upon language processing, to effectively ignore a word in the form of an actual (compressed) query in shorter form, found elsewhere in the log. The extra word in such cases ('icon') will be referred to as the extra term.

For help-and-support-center query logs, after the isolated per-query compression steps mentioned with respect to low and medium compression operations are executed, the compressed forms of all queries of a given length, such as length 5 are compared to (subsumed under) those of length 4 where possible. Then, the set of length 4 queries are compared to and subsumed under those of length 3 where possible. The process stops there for the particular domain's log files, but in principle could be applied starting with queries of length greater than 5 and stopping with queries of length less than 3.

The strong form of subsumption is essentially absolute. Thus, whenever a one-word difference exists between an N-word query and an (N-1)-word query, a subsumption relation is presumed and bundling of the longer with its shorter counterpart is always done. In accordance with one embodiment, a more nuanced form of subsumption is guided by vocabulary features. For example, where queries differ by one word, but that word is shown by dictionary look up to be a verb, and this verb is not a synonym to any pre-existing term (unlike "change" and "modify" for example), then the subsumption is blocked because "erase hard disk" and "recover hard disk" are truly different. Likewise if the extra term exists in any control vocabulary (for example, a list of Windows® system components) the subsumption is blocked. If no absolute blocking conditions apply, then the final decision can be statistically guided. A word that is very frequent is not likely to be a differentiator, so the application of subsumption will generally follow a threshholding rule on the frequency on the extra term.

Regardless of the manner in which the blocking filters are applied, the process of identifying an "extra" term when comparing each, for example, length five query with all length four queries should be done efficiently. A simple comparison between two strings, whether at character level (two words compared letter-by-letter as in spelling correction) or at token level (two phrases compared word-by-word) is called "edit distance." When the edit distance of token comparison of two query strings is exactly one, that means that only one token difference has been identified and accordingly that subsumption is possible. Preferably, the query strings are sorted by word tokens prior to the subsumption process, as part of an ordinary normalization process and such sorting is preferably a precondition for edit distance computation. Since edit distance computation can be very computationally intensive when applied to logs potentially containing millions of queries, subsumption preferably employees a shortcut. Specifically, for subsumption, full edit-distance computation is only attempted when a one-difference could in principle occur for the two strings being compared. Accordingly, a recheck for possible one-difference comparisons is generated using an index over all of the "short" strings by their first and second token words.

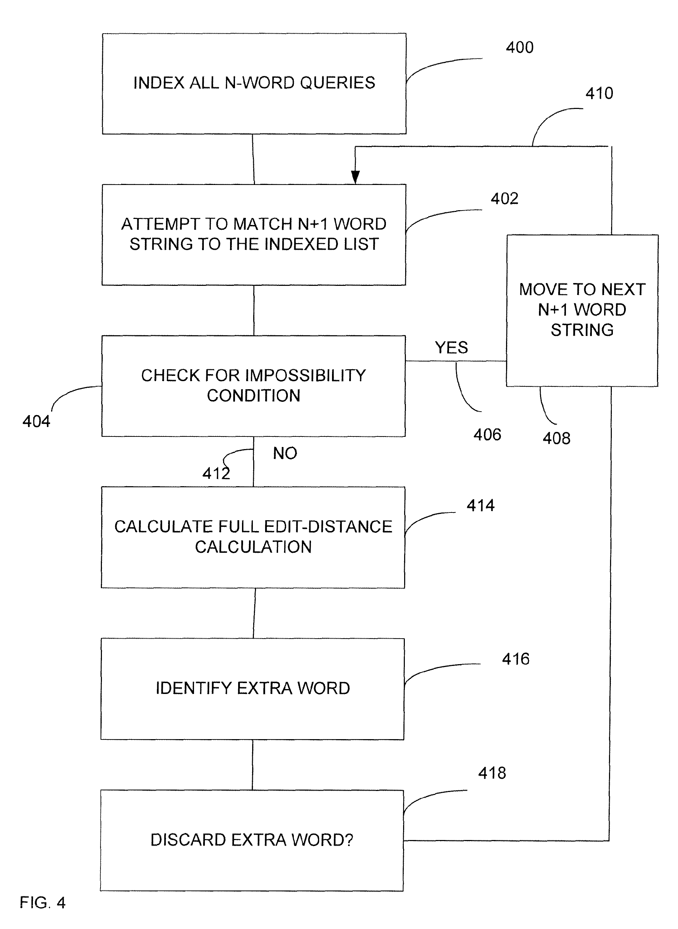

FIG. 4 is a diagrammatic view of a method for efficiently selectively performing full-edit distance comparisons between N+1 word strings and N word strings. The method begins at block 400 where all N word queries are indexed according to their first and second tokens. Words are examples of tokens, however, as used herein, tokens can be considered to be any grouping of characters that have linguistic meaning to people. For clarity of description, however, "words" are generally used to illustrate embodiments of the invention, although those skilled in the art will recognize that embodiments of the present invention can be practiced with any form of token in any language. The step of indexing the N token queries is optional since the method can be performed by sequentially checking the first two tokens of every comparisons list entry (each of the "shorter" strings) against the "longer" candidate every time a match is attempted. Indexing, however, saves a significant amount of time and is thus preferred. Once all N word queries have been indexed, block 402 executes by attempting to match an N+1 word string to the indexed list.

Once the matching string in the N word index is located, or the position of where such a matching N word query would be is determined, block 404 executes to determine whether an impossibility condition (IC) exists. If the first token of the shorter query differs from the first token of the longer query, and the second token of the shorter query differs from the second token of the longer query, then the impossibility condition exists and control passes along line 406 to block 408. At block 408, the next N+1 word query is selected and the process repeats by returning to block 402 via line 410. If, however, the impossibility condition does not exist, control passes along line 412 to block 414 where the full edit distance between the N+1 word query and the N word query is calculated. Implementing the impossibility condition check cuts useless full edit-distance comparison operation by approximately 50% based upon testing. Once the full edit-distance calculation at block 414 is complete, the extra word is identified at block 416 and at block 418, suitable processing, such as statistical processing and/or language processing is employed to determine whether the extra word may be discarded or whether it should be kept.

An example of a situation in which the impossibility condition would block full edit-distance calculation is illustrated in the following example. First, the pre-token-sorted examples are as follows:
"Help setup new personal secure user account."
"Setup new personal secure user computer work station."

These tokens are sorted prior to the subsumption process, the comparison is as follows:
"Account help new personal secure setup user."
"Computer new personal secure user work station."

As illustrated, the process of sorting the tokens prior to subsumption has essentially reordered each word to be in alphabetical order. As illustrated, the first two words of the two query strings are both different, accordingly the impossibility condition will block full testing of the edit-distance algorithm.

Embodiments of the present invention are useful to compress large query logs to varying levels of compression. This allows more efficient interaction with the meanings of each query by reducing the number of queries that are essentially duplicative and/or extraneous.

Although the present invention has been described with reference to particular embodiments, workers skilled in the art will recognize that changes may be made in form and detail without departing from the spirit and scope of the invention.

## Claims

1. A method of compressing a log of linguistic data, the log having a plurality of linguistic strings, each string being including at least two tokens, the method comprising:
applying a compression operation to each string;
determining if any two strings match each other after the compression operation; and
removing one of the two matching strings from the log.

2. The method of claim 1, wherein the log is a log of queries.

3. The method of claim 2, wherein the queries are queries relative to a help function.

4. The method of claim 3, wherein the help-related queries are relative to a computer system.

5. The method of claim 1, wherein the compression operation is character-based.

6. The method of claim 1, wherein the compression operation is token-based.

7. The method of claim 1, wherein the compression operation is subsumption.

8. The method of claim 7, wherein subsumption includes applying an impossibility condition to selectively compute edit distance.

9. The method of claim 1, and further comprising:
applying a second compression operation to each string;
determining if any two strings match each other after the second compression operation; and
removing one of the two matching strings from the log.

10. The method of claim 9, wherein the first compression operation is character-based and the second compression operation is token based.

11. The method of claim 10, and further comprising applying subsumption after the second compression operation is complete.

12. The method of claim 11, wherein the subsumption operation is repeated for the log.

13. The method of claim 1, and further comprising training a statistical process with the compressed log.

14. A system for compressing a query log having a plurality of linguistic strings, each string having a plurality of tokens, the system comprising:
an input for receiving a raw query log;
memory for storing the raw query log;
a processor for applying at least one compression operation to each string, and for scanning the modified strings to determine if any match each other so that one of the matching strings can be removed; and
an output for providing a compressed query log once the removal is complete.

15. The system of claim 14, wherein the queries are queries relative to a help function.

16. The system of claim 14, wherein the help-related queries are relative to a computer system.

17. The system of claim 14, wherein the at least one compression operation is character-based.

18. The system of claim 14, wherein the at least one compression operation is token-based.

19. The system of claim 14, wherein the at least one compression operation includes subsumption.

20. The system of claim 19, wherein subsumption includes applying an impossibility condition to selectively compute edit distance.

21. The system of claim 14, and further adapted to apply at least a second compression operation to each string, determine if any two strings match each other after the second compression operation, and remove one of the two matching strings from the log.

22. The system of claim 21, wherein the first compression operation is character-based and the second compression operation is token based.

23. The system of claim 22, and further comprising applying subsumption after the second compression operation is complete.

24. The system of claim 23, wherein the subsumption operation is repeated for the log.

25. The system of claim 14, and further comprising training a statistical process with the compressed log.
